# EUROPÄISCHE PATENTSCHRIFT

(11) **EP 1 190 168 B1**
(45) Veröffentlichungstag und Bekanntmachung des Hinweises auf die Patenterteilung: **17.08.2005**
(21) Anmeldenummer: 00979443.9
(22) Anmeldetag: 21.10.2000
(51) Int. Cl.: F02M 1/00

(54) **AKTOR**
ACTUATOR
ACTIONNEUR

(30) Priorität: 22.10.1999 DE 19951012
(43) Veröffentlichungstag der Anmeldung: 27.03.2002
(73) Patentinhaber: ROBERT BOSCH GMBH, 70442 Stuttgart (DE)
(72) Erfinder: RUEHLE, Wolfgang, 71254 Ditzingen (DE); STIER, Hubert, 71679 Asperg (DE); BOEE, Matthias, 71640 Ludwigsburg (DE); HOHL, Guenther, 70569 Stuttgart (DE); KEIM, Norbert, 74369 Loechgau (DE)
(86) Internationale Anmeldenummer: PCT/DE2000/003698
(87) Internationale Veröffentlichungsnummer: WO 2001/031187

(56) Entgegenhaltungen:
- DE-A- 4 228 974
- DE-A- 19 744 235

## Beschreibung

### Stand der Technik

Die Erfindung geht aus von einem Aktor nach der Gattung des Hauptanspruchs.

Üblicherweise werden Aktoren zur Betätigung von Brennstoffeinspritzventilen für Brennstoffeinspritzanlagen von Brennkraftmaschinen zur Vermeidung von Zugspannungen durch eine Feder vorgespannt. Gewöhnlich wird zur Erzeugung einer Vorspannung die auch bei geschlossenem Brennstoffeinspritzventil vorhandene Restspannung der Rückstellfeder des Ventils genutzt. Eine solche Anordnung ist z. B. aus der DE 195 34 445 C 2 bekannt. Der Aktor sitzt auf einem Widerlager auf, welches durch die Rückstellfeder gegen eine Druckschulter gedrückt wird.

Nachteilig an dieser Bauform ist die nicht voreinstellbare Vorspannung des Aktors. Daraus resultieren Beschädigungen des Bauteils vor oder während des Einbaus. Da der Aktor nicht monolithisch gefertigt ist, sondern aus mehreren piezoelektrischen oder magnetostriktiven Schichten aus Keramik besteht, ist der Aktor sehr empfindlich gegen Scherkräfte, die sehr schnell zur Zerstörung des Bauteils führen können.

Aus der DE 42 28 974 A1 ist bereits ein piezoelektrischer Aktor bekannt, der eine Vielzahl von Piezoelementen aufweist, die als Ringe ausgebildet sind und die mittels einer Befestigungseinrichtung zu einer mechanisch vorgespannten Piezoelement-Säule zusammengefasst sind. Die Befestigungseinrichtung weist ein Stangenelement auf, das sich durch einen Zentralraum der Piezoelement-Säule hindurch erstreckt und das an seinen beiden Endabschnitten gegen die entsprechenden Piezoelemente drückende plattenförmige Befestigungsorgane besitzt. Mindestens eines der Befestigungsorgane ist mit einem Vorspannelement versehen, das aus einer Formgedächtnislegierung besteht und das bei geeigneter Temperaturänderung zur mechanischen Vorspannung der Piezoelement-Säule ohne Einwirkung eines Drehmoments seine axiale Abmessung ändert. Das Vorspannelement ist dabei zwischen dem unteren Befestigungsorgan und einer unteren Bodenplatte eingespannt, während das obere Befestigungsorgan unmittelbar an einer oberen Deckplatte anliegt.

### Vorteile der Erfindung

Der erfindungsgemäße Aktor mit den Merkmalen des Hauptanspruchs hat demgegenüber den Vorteil, daß durch Verwendung einer Vorspanneinrichtung eine variable Vorspannung des Aktors möglich ist, wobei die Vorspannung bereits bei der Herstellung des Aktors erfolgt, so daß der Aktor auch bei der Montage keiner Zugbeanspruchung ausgesetzt ist.

Es ist vorteilhaft, den Aktor bereits vorgespannt in das Brennstoffeinspritzventil einzubauen, da Beschädigungen des Bauteils auf diese Weise vorgebeugt wird.

Ferner läßt sich die Vorspanneinrichtung mit geringem Fertigungsaufwand und praktisch ohne zusätzlichen Bauraum realisieren.

Die Verwendung eines zentralen Zugankers für die Vorspanneinrichtung bietet den Vorteil der raumsparenden Unterbringung der Vorspanneinrichtung in einer zentralen Ausnehmung des Aktors. Diese Ausführung schützt den Aktor gegen Zerstörung durch Scherkräfte und erlaubt den vorgespannten Einbau des Aktors. Die Vorspanneinrichtung ist technisch einfach und kostengünstig zu realisieren.

Auch durch die in den Unteransprüchen aufgeführten Maßnahmen sind vorteilhafte Weiterbildungen und Verbesserungen des im Hauptanspruch gegebenen Aktors möglich.

### Zeichnung

Ausführungsbeispiele der Erfindung sind in der Zeichnung vereinfacht dargestellt und in der nachfolgenden Beschreibung näher erläutert. Es zeigen:
- Fig. 1: einen axialen Schnitt durch ein Ausführungsbeispiel eines erfindungsgemäßen Aktors und
- Fig. 2: einen axialen Schnitt durch ein nicht erfindungsgemäßes Ausführungsbeispiel eines Aktors .

### Beschreibung der Ausführungsbeispiele

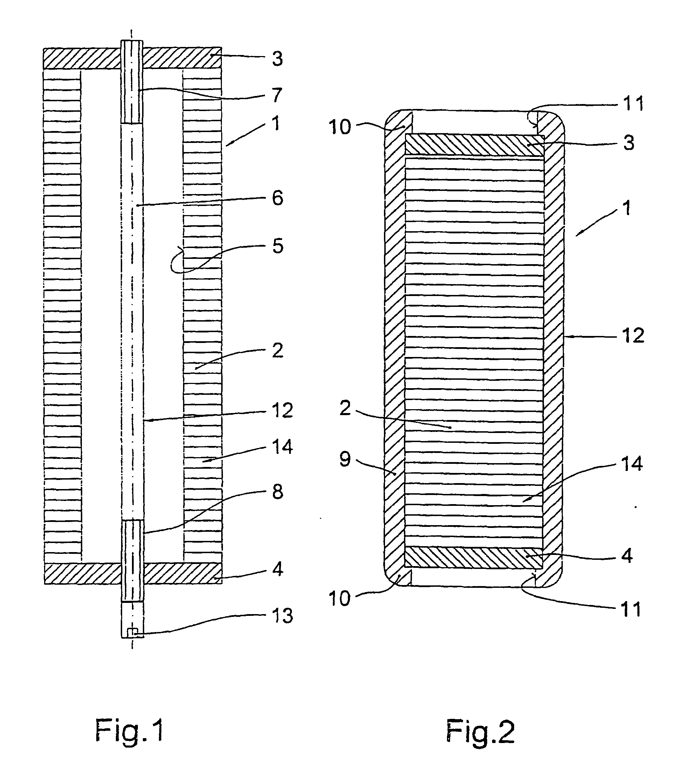

Fig. 1 zeigt in einer axialen Schnittdarstellung ein Ausführungsbeispiel des erfindungsgemäßen piezoelektrischen oder magnetostriktiven Aktors 1. Der Aktor 1 dient z. B. zur Betätigung eines Brennstoffeinspritzventils, insbesondere für die Benzin-Direkteinspritzung.

Der Aktor 1 besteht aus einem piezoelektrischen oder magnetostriktiven Element 14. Dieses kann sowohl monolithisch ausgeführt sein als auch, wie in Fig. 1 dargestellt, aus scheibenförmigen piezoelektrischen oder magnetostriktiven Schichten 2 bestehen. Die Schichten 2 können untereinander verklebt sein. Der Aktor 1 weist eine Deckplatte 3 und eine Bodenplatte 4 auf, die den Aktor 1 endseitig abschließen, mit den Schichten 2 z. B. verklebt sind und der Kraftübertragung auf die Schichten 2 dienen.

Der Aktor 1 weist im in Fig. 1 dargestellten Ausführungsbeispiel eine zentrale Ausnehmung 5 auf, in welcher sich ein Zuganker 6 axial erstreckt und die Deckplatte 3 mit der Bodenplatte 4 kraftschlüssig verbindet. Der eine Vorspanneinrichtung 12 bildende Zuganker 6 ist vorzugsweise stangenförmig, z. B. als Gewindestange ausgeführt. Der Zuganker 6 ist mit einem ersten Gewinde 7 versehen, welches den Zuganker 6 in der Deckplatte 3 fixiert, und mit einem zweiten Gewinde 8, welches den Zuganker 6 in der Bodenplatte 4 fixiert. Das erste Gewinde 7 ist vorzugsweise als Rechtsgewinde, das zweite Gewinde 8 vorzugsweise als Linksgewinde ausgebildet.

Die Vorspannung des Aktors 1 ist durch Drehen des Zugankers 6 einstellbar. Der Abstand der Deckplatte 3 von der Bodenplatte 4 wird dadurch vergrößert oder verkleinert und erzeugt dementsprechend eine stärkere oder geringere Vorspannung der scheibenförmigen Schichten 2.

Für den Angriff eines Werkzeugs kann an dem Zuganker 6 eine Schlitznut 13 vorgesehen sein. Der zuganker 6 kann rohrförmig ausgeführt sein, um eine Ventilnadel oder einen Druckkolben koaxial aufzunehmen.

Der Aktor 1 ist zur Verwendung in einem nicht weiter dargestellten Brennstoffeinspritzventil von einem Ventilgehäuse umgeben, an welchem sich z. B. die Deckplatte 3 abstützt, während in der zentralen Ausnehmung 5 des Aktors 1 eine Ventilnadel geführt ist, welche abspritzseitig einen Ventilschließkörper aufweist, der mit einer Ventilsitzfläche einen Dichtsitz bildet. Das Brennstoffeinspritzventil kann beispielsweise als nach außen öffnendes Brennstoffeinspritzventil ausgeführt sein.

Wird dem Aktor 1 eine elektrische Spannung zugeführt, dehnt sich das piezoelektrische Element 14 aus und betätigt beispielsweise über die Bodenplatte 4 und einen Mitnehmer die Ventilnadel, wodurch der Ventilschließkörper vom Dichtsitz abhebt und Brennstoff abgespritzt wird.

Fig. 2 zeigt in einer axialen Schnittdarstellung ein Ausführungsbeispiel eines nicht erfindungsgemäßen piezoelektrischen oder magnetostriktiven Aktors 1. Bereits beschriebene Elemente sind mit übereinstimmenden Bezugszeichen versehen, so daß sich eine wiederholende Beschreibung erübrigt.

Der Aktor 1 kann wie im ersten Ausführungsbeispiel monolithisch oder geschichtet ausgeführt werden. Das in Fig. 2 dargestellte piezoelektrische oder magnetostriktive Element 14 ist aus piezoelektrischen oder magnetostriktiven Schichten 2 aufgebaut. Die Schichten 2 sind bei diesem Ausführungsbeispiel von einer Ummantelung 9 umgeben, welche an ihren endseitigen Überständen 10 so umgebördelt ist, daß sie den Rand der Deckplatte 3 und der Bodenplatte 4 umschließt und eine axiale Kraftkomponente auf die Deckplatte 3 und die Bodenplatte 4 ausübt. Diese axiale Kraftkomponente erzeugt eine axiale Vorspannkraft in den Schichten 2.

Durch das Umbördeln bleibt an den Überständen 10 eine Ausnehmung 11, welche zum Anschluß an einen Druckkolben dienen kann, welcher von der Deckplatte 3 und der Bodenplatte 4 betätigt wird. Von der Bodenplatte 4 kann beispielsweise eine Ventilnadel oder ein Kolben einer hydraulischen Hubeinrichtung betätigt werden, um den durch das piezoelektrische oder magnetostriktive Element ausgeübten Hub auf einen Ventilschließkörper zu übertragen, z. B. um Brennstoff in den Brennraum einer Brennkraftmaschine einzuspritzen. Die Deckplatte 3 ist z. B. mit einem Ventilgehäuse fest verbunden.

Die Erfindung ist nicht auf die dargestellten Ausführungsbeispiele beschränkt und insbesondere bei einer Vielzahl von Bauweisen von Brennstoffeinspritzventilen anwendbar.

## Patentansprüche

1. Aktor (1), insbesondere zur Betätigung von Brennstoffeinspritzventilen für Brennstoffeinspritzanlagen von Brennkraftmaschinen, mit einem piezoelektrischen oder magnetostriktiven Element (14), und mit einer Vorspanneinrichtung (12), die das piezoelektrische oder magnetostriktive Element (14) zur Ausübung einer axialen Vorspannkraft auf das piezoelektrische oder magnetostriktive Element (14) durchdringt, wobei der Aktor (1) eine zentrale Ausnehmung (5) zur Aufnahme der Vorspanneinrichtung (12) aufweist, in der ein Zuganker (6) der Vorspanneinrichtung (12) angeordnet ist, der je eine das piezoelektrische oder magnetostriktive Element (14) endseitig abschließende Deckplatte (3) und Bodenplatte (4) kraftschlüssig verbindet,
**dadurch gekennzeichnet,**
**dass** der Zuganker (6) durch ein erstes Gewinde (7) an der Deckplatte (3) und durch ein zweites Gewinde (8) an der Bodenplatte (4) fixiert ist und die Vorspannung des Aktors (1) durch Verdrehen des Zugankers (6) einstellbar ist.

2. Aktor nach Anspruch 1,
**dadurch gekennzeichnet,**
**dass** das piezoelektrische oder magnetostriktive Element (14) aus mehreren gestapelt angeordneten Schichten (2) besteht.

3. Aktor nach Anspruch 1,
**dadurch gekennzeichnet,**
**dass** das erste Gewinde (7) und das zweite Gewinde (8) zueinander gegenläufig ausgebildet sind.

4. Aktor nach Anspruch 2,
**dadurch gekennzeichnet,**
**dass** eine Ummantelung (9) die Schichten (2) umgibt.

## Claims

1. Actuator (1), in particular for the actuation of fuel injection valves for fuel injection systems of internal combustion engines, having a piezoelectric or magnetostrictive element (14), and having a prestressing device (12) which penetrates the piezoelectric or magnetostrictive element (14) in order to exert an axial prestressing force on the piezoelectric or magnetostrictive element (14), the actuator (1) having a central recess (5) for accommodating the prestressing device (12), in which recess (5) a tie rod (6) of the prestressing device (12) is arranged, the said tie rod (6) connecting in each case one cover plate (3), which closes off the end of the piezoelectric or magnetostrictive element (14), and a base plate (4) with a force-transmitting fit, **characterized in that** the tie rod (6) is fixed to the cover plate (3) by a first thread (7) and to the base plate (4) by a second thread (8), and the prestress of the actuator (1) can be adjusted by rotating the tie rod (6).

2. Actuator according to Claim 1, **characterized in that** the piezoelectric or magnetostrictive element (14) is composed of a plurality of layers (2) arranged in a stack.

3. Actuator according to Claim 1, **characterized in that** the first thread (7) and the second thread (8) are configured so as to run in opposite directions to one another.

4. Actuator according to Claim 2, **characterized in that** a covering (9) surrounds the layers (2).

## Revendications

1. Actionneur (1), en particulier pour des injecteurs de carburant d'installations d'injection de carburant de moteurs à combustion interne, comprenant un élément piézoélectrique ou magnétostrictif (14), et un dispositif de précontrainte (12) qui traverse l'élément piézoélectrique ou magnétostrictif (14) pour exercer une force de précontrainte axiale sur l'élément piézoélectrique ou magnétostrictif (14), l'actionneur (1) présentant un évidement central (5) destiné à recevoir le dispositif de précontrainte (12) et dans lequel est disposé un tirant d'ancrage (6) du dispositif de précontrainte (12) qui relie par action de force des plaques de couvercle (3) et de fond (4) qui enferment respectivement l'élément piézoélectrique ou magnétostrictif (14) à ses extrémités,
**caractérisé en ce que**
le tirant d'ancrage (6) est fixé à la plaque de couvercle (3) par un premier filetage (7) et à la plaque de fond (4) par un second filetage (8) et la précontrainte de l'actionneur (1) peut être réglée par rotation du tirant d'ancrage (6).

2. Actionneur selon la revendication 1,
**caractérisé en ce que**
l'élément piézoélectrique ou magnétostrictif (14) est composé de plusieurs couches (2) disposées en empilement.

3. Actionneur selon la revendication 1,
**caractérisé en ce que**
le premier filetage (7) et le second filetage (8) sont de pas inverses l'un de l'autre.

4. Actionneur selon la revendication 2,
**caractérisé en ce qu'**
une enveloppe (9) entoure les couches (2).
